# EUROPEAN PATENT APPLICATION

(11) **EP 1 091 015 A1**
(43) Date of publication of application: **11.04.2001**
(21) Application number: 99970555.1
(22) Date of filing: 29.06.1999
(51) Int. Cl.: C23C 14/34

(54) **Co-Ti ALLOY SPUTTERING TARGET AND MANUFACTURING METHOD THEREOF**

(30) Priority: 20.11.1998 JP 33033398
(71) Applicant: JAPAN ENERGY CORPORATION, Tokyo 105-0001 (JP)
(72) Inventor: Takahashi, K., Isohara Fact. Japan Energy Corp., Kitaibaraki-shi, Ibaraki-ken 319-1535 (JP)
(74) Representative: Meddle, Alan Leonard
(86) International application number: JP9903479
(87) International publication number: WO0031316

(57) **Abstract**

A Co-Ti sputtering target is manufactured by forming a Co-Ti alloy ingot by vacuum melting and casting a Co-Ti alloy containing 0.5 to 20 atomic percent Ti, and fabricating the target by hot-working the ingot. The oxygen content of the sputtering target is 100 ppm or less, and the crystal grain diameter is 50 µm or less. This Co-Ti sputtering target has a low oxygen content as described above, forms films with good uniformity, and produces sputtered thin films forming few particles.

## Description

### Technical Field

The present invention relates to a Co-based alloy sputtering target having a low oxygen content and good uniformity in film forming, which can produce a sputtered thin film having a small number of particles.

### Background Art

Sputtering is widely used for forming semiconductor thin films. Sputtering utilizes the principle in which a substrate used as an anode and a target used as a cathode are made to face to each other, a high voltage is impressed between the substrate and the target in an inert gas atmosphere to create an electric field, electrons then ionized collide with the inert gas to form plasma, cations in the plasma collide with the surface of the target to release atoms constituting the target, and the released atoms deposit on the surface of the facing substrate to form a film.

Presently, most of sputtering generally used is performed by the method known as magnetron sputtering. Magnetron sputtering is a method for sputtering by installing a magnet on the back side of a target, and creating a magnetic field on the surface of the target in the direction perpendicular to the electric field. This method advantageously stabilize and densify plasma, and increase the sputtering speed in such an orthogonal electromagnetic field space.

Such magnetron sputtering is generally utilized for forming thin films on substrates.

Heretofore, thin films formed by Co-Ti alloy sputtering targets have required stringent control of Ti content, and have required to be formed uniformly on substrates.

One of the methods, for forming such thin films formed by Co-Ti alloy sputtering targets is a method in which two types of targets, a Co target and a Ti target, are provided, these are alternately sputtered onto a substrate to deposit a desired thickness of film, which is heat-treated to form a desired Co-Ti alloy thin film. However, this method is not practical because it disadvantageously involves a number of processes for forming a thin film, and the control of film thickness is complicated, resulting in high costs.

Therefore, as an alternative method, the use of a target known as a mosaic target, in which Co plates and Ti plates are alternately arranged on a plane, was proposed. Although this method is effective in that two types of targets, a Co target and a Ti target, are not required to replace at the time of sputtering, it has disadvantages because the uniformity of film formation is poor, the composition of the Co-Ti alloy becomes uneven on the wafer, and the quality is low.

In order to overcome the above-described disadvantages, a sintered target, which is often used in refractory metal targets made of suicides, W, or Mo, has been used.

However, there are some problems in the manufacturing process for such sintered targets. That is, since it is difficult to obtain a high-purity Co powder material suitable for semiconductor devices, a special manufacturing process is required for obtaining such a powder material, leading to an extremely high manufacturing costs.

Also, the sintered target has a problem of increase in the electric resistance of the Co-Ti alloy film because of the high oxygen content of the sintered target.

Since however the manufacturing conditions are improved, the sintered target cannot have 100% density, the resultant low density of the sintered target is one of the causes for the production of particles.

Furthermore, the sintered target has another disadvantage in that no discharge occurs unless the pressure of Ar gas is raised during sputtering making discharge unstable, the variation of the depositing rate is significant, and the control of permeability is very difficult.

For the above reasons, the range of film forming conditions for obtaining desired properties is extremely narrow, and satisfactory Co-Ti alloy targets have not been obtained.

Therefore, it is the object of the present invention to provide a Co-Ti alloy sputtering target and a method for the manufacture thereof, wherein a target made of a Co-Ti alloy magnetic material is formed by the melting method, and the quantity of oxygen is lowered, for simplifying the target manufacturing process and the film forming process, and obtaining thin films of high uniformity.

### Disclosure of the Invention

In order to solve the above problems, the present inventors found that the uniformity of film formation could be improved, the quantity of oxygen can be reduced, and a high-quality thin film can be obtained in good reproducibility under stable manufacturing conditions, by manufacturing a Co-Ti alloy sputtering target by the vacuum melting method.

On the basis of the above-described findings, according to a first aspect of the present invention, there is provided a sputtering target comprising a Co-Ti alloy, wherein said sputtering target contains 0.5 to 20 atomic percent Ti, and manufactured by vacuum melting.

According to a second aspect of the present invention, there is provided the sputtering target according to the first aspect, wherein the content of oxygen is 100 ppm or less.

According to a third aspect of the present invention, there is provided the sputtering target according to the first or second aspect, wherein the crystal grain diameter is 50 µm or less.

According to a fourth aspect of the present invention, there is provided the sputtering target according to any of the first through third aspects, wherein the maximum permeability in the surface direction is less than 30, and the maximum permeability in the thickness direction is 5 or more and less than 100.

According to a fifth aspect of the present invention, there is provided a method for manufacturing a Co-Ti alloy sputtering target, comprising the steps of forming a Co-Ti alloy ingot by vacuum melting and casting a Co-Ti alloy containing 0.5 to 20 atomic percent Ti, and fabricating the target by hot-working said ingot.

### Brief Description of the Drawing

FIG. 1 is a schematic diagram showing the locations of composition analyses on a wafer.

### Detailed Description of the Preferred Embodiments

The Co-Ti alloy sputtering target of the present invention contains 0.5 to 20 at % Ti. The balance is basically Co, but tolerated unavoidable impurities may be contained. On the manufacture of such a target, high-quality Co and Ti are first melted under a vacuum. Although high-purity Co is used as the material for Co, commercially available Co of a purity of 99.9% or higher may also be used. Ti used must have a purity of 99.995% or higher.

This Co-Ti alloy is melted, and cast into a desired block (ingot), which is hot-forged or hot-rolled and processed into a flat plate-like target shape or other shapes which can be set in magnetron sputtering equipment.

The above-described hot processing is performed within a temperature range between 800 and 1190°C. This hot processing is effective as means for densifying the relatively coarse structure as cast, and for making crystal grains finer.

This hot processing further improves the quality of the target of the present invention.

The alloy target of the present invention thus obtained has the oxygen content of 100 ppm or below, and has a dense structure having the crystal grain diameter of 50 µm or smaller.

Furthermore, the oxygen content and crystal grain diameter of the Co-Ti alloy target of the present invention can be 80 ppm or below and 30µm or smaller, respectively.

The reason why the Ti content of the sputtering target of the present invention is determined to be 0.5 to 20 at % is that if the Ti content exceeds 20 at %, the flatness of the sputtered film is degraded and specific resistance increases, and if it is less than 0.5 at %, containing Ti is becomes meaningless.

Also, the target having an oxygen content of 100 ppm or below can be obtained easily according to the method of the present invention, and since the oxygen content exceeds 100 ppm, the electrical resistance of the thin magnetic Co-Ti alloy film increases, it is necessary to establish the upper limit of the oxygen content to be this value. Preferably, the oxygen content of the target is 80 ppm or below as described above.

By sputtering film formation using the Co-Ti alloy target of the present invention having a dense structure with crystal grain diameters of 50 µm or below, a thin Co-Ti alloy film having uniformity much superior to the uniformity of conventional sintered target can be formed on a substrate (wafer).

The reason why the above-described hot working is performed within the temperature range between 800°C and 1190°C is to eliminate the segregation of Ti in the ingot producing stage, and to perform hot working without cracking.

The above-described Co-Ti alloy sputtering target of the present invention has a maximum permeability in the surface direction of less than 30, and a maximum permeability in the thickness direction of 5 or more and less than 100.

By the use of the low-permeability Co-Ti alloy sputtering target manufactured by the melting method, discharging is stabilized, and a thin film with few defects such as particles can be obtained.

Also, since the variation of the Ti content in the Co-Ti alloy target of the present invention becomes ± 0.2% by weight, stable films can be obtained in a high reproducibility.

Since the oxygen content of the thin film obtained by sputtering can be 100 ppm or below, preferably 80 ppm or below, as in the target, films having low resistance can be formed. Furthermore, the thin film itself has a uniform thickness and a dense structure without the segregation of the components, and excels in uniformity.

### Example and Comparative Examples

The present invention will further be described below referring to Examples and Comparative Examples. However, these are specifically used for exemplifying the present invention, and the present invention is by no means limited by these examples. That is, the present invention is only limited by the appended claims, and various modifications and changes other than these examples fall within the spirit and scope of the present invention.

### (Example 1)

A Co-Ti alloy was melted under a vacuum in a vacuum induction blast furnace using Co of a purity of 99.99% or higher and Ti of a purity of 99.995% or higher. The two types of melts were Co-10 at % Ti and Co-15 at % Ti.

Table 1 shows the composition of these alloys. After the above-described Co-Ti alloys were melted and cast, the resultant ingots (170 mm × 200 mm × 30 mm t) were subjected to constant-heat treatment (at 1100°C for 2 hours), and hot-rolled in 1-heat and 1-pass to a thickness of 12 mm t.

Samples were cut from the hot-rolled plates, and the analysis of oxygen contents, the measurement of magnetic properties, and the microscopic observation of the structures were performed. The oxygen contents were measured using a LECO oxygen analyzer.

The magnetic properties were measured using a B-H meter with a 4πI coil at a maximum magnetic field of 1000 Oe. The structures were observed using an optical microscope after polishing and etching the cross-sections of the samples.

**[Table 1]**

| | Composition | Remarks |
|---|---|---|
| Example 1 | Co-10 at % Ti | Melted |
| | Co-15 at % Ti | Melted |
| Comparative Example 1 | Co-10 at % Ti | Sintered |
| | Co-15 at % Ti | Sintered |

The results of oxygen content analysis are shown in Table 2. As Table 2 shows, the oxygen content of the two types of Co-Ti alloys of this example was 75 ppm, which was lower than the oxygen content of the sintered target of comparative examples described later. Also, the results of measurement of magnetic properties showed that the maximum permeability in the surface direction was less than 30, and the maximum permeability in the thickness direction was 5 or more and less than 100 and a Co-Ti alloy of a low permeability was obtained. Furthermore, the observation through an optical microscope showed that the Co-Ti alloy has a dense structure free of cracking and the segregation of the components.

**[Table 2]**

| | Composition | Oxygen content | Remarks |
|---|---|---|---|
| Example 1 | Co-10 at % Ti | 75 ppm | Melted |
| | Co-10 at % Ti | 75 ppm | Melted |
| Comparative Example 1 | Co-10 at % Ti | 360 ppm | Sintered |
| | Co-15 at % Ti | 370 ppm | Sintered |

### (Comparative Example 1)

Co powder of a purity of 99.99% or higher and Ti powder of a purity of 99.995% or higher were used as the materials, and sintered under a vacuum at 1150°C using a hot press. The two types of sintered products were Co-10 at % Ti and Co-15 at % Ti. The composition of these alloys are shown in Table 1.

Samples were cut from the sintered products, and the analysis of oxygen contents, the measurement of magnetic properties, and the microscopic observation of the structures were performed using the same apparatuses as in Example 1.

The results of oxygen content measurement are shown in Table 2. As Table 2 shows, the oxygen contents of the two types of Co-Ti sintered target of this example were 360 ppm and 370 ppm, respectively. Compared with melted and rolled products of Example 1, the oxygen contents increased unfavorably.

The observation of the samples through an optical microscope showed a coarse structure inherent to sintered products, and a dense structure as in melted products could not be obtained. Also, the results of measurement of magnetic properties showed that the samples had a high permeability and were inferior to Example 1.

Next, in order to check the quantity of particles produced by sputtering and the variation of component composition in the thin film, targets of a diameter of 3 inches were fabricated from the rolled plates of Co-10 at % Ti and Co-15 at % Ti in Example 1, and the sintered plates of Co-10 at % Ti and Co-15 at % Ti in Comparative Example 1.

### (Comparative Example 2)

Also, in order to compare an integral rolled target with a sintered target, a mosaic target was prepared. Co and Ti of this mosaic target had the same purity as those of Example 1, and were individually melted and rolled under the same conditions of Example 1.

A mosaic target of the same size (3-inch diameter) was fabricated from thus obtained rolled plates by placing Ti chips (3-mm square) on a Co target so as to be the same area ratio of the surface eroded by sputtering same as Example 1.

The above-described target was used for forming a thin film on a silicon wafer using sputtering equipment, and the formation of particles larger than 0.3 µm and the variation of the composition in the thin film were checked. The formation of the particles were measured using a particle counter, and the component composition in the thin film was quantitatively analyzed using EPMA.

The sputtering conditions were the distance to the substrate of 60 mm, a gas (Ar) pressure of 0.5 Pa, and a voltage of 500 V.

The results of particle measurement is shown in Table 3. As is obvious from Table 3, the formation of particles of the target fabricated by melting and rolling in Example 1 was as little as 0/cm² and 0.02/cm², respectively.

Whereas the sintered target of Comparative Example 1 exhibited the formation of particles 10 times or more, and showed unfavorable results.

Although the quantity of particles formed from the mosaic target fabricated from the melted and rolled product of Comparative Example 2 was small compared with the sintered target of Comparative Example 1, it was still slightly large compared with the integral type of melted and rolled target of Example 1.

**[Table 3]**

| | Composition | Number of particles (/cm²) | Remarks |
|---|---|---|---|
| Example 1 | Co-10 at % Ti | 0 | Melted |
| | Co-15 at % Ti | 0.02 | Melted |
| Comparative Example 1 | Co-10 at % Ti | 0.21 | Sintered |
| | Co-15 at % Ti | 0.32 | Sintered |
| Comparative Example 2 | Co-10 at % Ti | 0.01 | Mosaic |
| | Co-15 at % Ti | 0.02 | Mosaic |

Next, the results of measurement of variation in the composition (Ti) of the thin film formed on a silicon wafer is shown in Table 4. The locations of measurement on the thin film formed on the silicon wafer is shown in FIG. 1. Corresponding to the locations of measurement shown in FIG. 1, the analytical values are shown in Table 4.

As is obvious from Table 4, the variation of the composition (Ti) was small in the integral type of melted and rolled targets of Example 1 and the sintered targets of Comparative Example 1, while the variation of the composition was unfavorably large in the mosaic target.

Since the mosaic target forms a small quantity of particles and the manufacturing process is simple, it seems to be advantageous; however, it is not preferable as long as the variation of the composition exists.

From the above results, the integral type of target (Example 1) fabricated by melting and rolling, producing a small number of particles and exhibiting a small variation of the composition of the film formed on the wafer is said to be the best target.

**[Table 4]**

| | Composition | Result of qualitative analysis (at % Ti) | | | | | | Remarks |
|---|---|---|---|---|---|---|---|---|
| | | A | B | C | D | E | F | |
| Example 1 | Co-10 at % Ti | 9.9 | 10 | 10 | 10.1 | 10 | 9.9 | Melted |
| | Co-15 at % Ti | 14.9 | 15 | 15 | 14.9 | 15 | 15.1 | Melted |
| Comparative Example 1 | Co-10 at % Ti | 10 | 10 | 10 | 9.9 | 9.9 | 10 | Sintered |
| | Co-15 at % Ti | 15 | 15 | 15.1 | 15.1 | 14.9 | 15.2 | Sintered |
| Comparative Example 2 | Co-10 at % Ti | 10.3 | 11.1 | 9.7 | 9.5 | 10.9 | 8.9 | Mosaic |
| | Co-15 at % Ti | 16.1 | 14.3 | 13.7 | 13.9 | 15.1 | 13.8 | Mosaic |

### Effect of the Invention

The Co-Ti alloy sputtering target of the present invention is manufactured by melting and casting Co and Ti so as to contain 0.5 to 20 at % Ti to form a Co-Ti alloy ingot, and hot-processing this ingot to have a crystal grain diameter of 50 µm or less and an oxygen content of 100 ppm or less.

The Co-Ti alloy target thus manufactured can be made the variation of Ti content ± 0.2% by weight, and can be used for forming a sputtered thin film having a low permeability and a low electrical resistance, and forming few particles on a wafer.

The Co-Ti alloy target also facilitates the control of permeability, and has no problem that no discharging occurs unless the Ar gas pressure is elevated as observed in sintered targets.

Thus, the Co-Ti alloy sputtering target of the present invention has significant effects in that discharging can be stabilized, the variation of film forming rate can be minimized, the range of conditions for forming the thin Co-Ti alloy films are wide, the stable films can be formed with high reproducibility, the Co-Ti alloy target has excellent properties compared with conventional mosaic targets or sintered targets, and the manufacturing costs can be reduced.

## Claims

1. A sputtering target comprising a Co-Ti alloy, wherein said sputtering target contains 0.5 to 20 atomic percent Ti, and is manufactured by vacuum melting.

2. The sputtering target according to claim 1, wherein the content of oxygen is 100 ppm or less.

3. The sputtering target according to claim 1 or 2, wherein the crystal grain diameter is 50 µm or less.

4. The sputtering target according to any one of claims 1 to 3, wherein the maximum permeability in the surface direction is less than 30, and the maximum permeability in the thickness direction is 5 or more, and less than 100.

5. A method for manufacturing a Co-Ti alloy sputtering target, comprising the steps of forming a Co-Ti alloy ingot by vacuum melting and casting a Co-Ti alloy containing 0.5 to 20 atomic percent Ti, and fabricating the target by hot-working said ingot.
